Europäisches Patentamt

European Patent Office

Office européen des brevets

(19)

(11) Publication number: **0 067 586**
**B1**

## EUROPEAN PATENT SPECIFICATION

(12)

(45) Date of publication of patent specification: **07.09.88**

(21) Application number: **82302740.4**

(22) Date of filing: **27.05.82**

(51) Int. Cl.⁴: **H 01 L 27/15,** H 01 L 33/00

(54) Electro-optic element and method of making the same.

(30) Priority: **11.06.81 US 272603**

(43) Date of publication of application:
**22.12.82 Bulletin 82/51**

(45) Publication of the grant of the patent:
**07.09.88 Bulletin 88/36**

(84) Designated Contracting States:
**DE FR GB**

(56) References cited:
**US-A-4 166 278**
**PROCEEDINGS OF THE OPTICAL COMMUNICATION CONFERENCE, Amsterdam, 17th-19th September 1979, pages 4.5-1 - 4.5-4; W.SUSAKI et al.: "Long lived single mode junction-up TJS lasers by improving electron injection efficiency"**
**JOURNAL OF APPLIED PHYSICS, vol. 45, no. 6, June 1974, pages 2785-2786, American Institute of Physics; H.NAMIZAKI et al.: "Transverse-junction-stripe-geometry double-heterostructure lasers with very low threshold current"**

(73) Proprietor: **HONEYWELL INC.**
**Honeywell Plaza**
**Minneapolis Minnesota 55408 (US)**

(72) Inventor: **Kolbas, Robert M.**
**8367 W. 101 st St. Circle**
**Bloomington Minnesota 55438 (US)**

(74) Representative: **Frohwitter, Bernhard, Dipl.-Ing.**
**Bardehle-Pagenberg-Dost-Altenburg & Partner**
**Patent- und Rechtsanwälte Galileiplatz 1**
**Postfach 86 06 20**
**8000 München 80 (DE)**

(56) References cited:
**LASER FOCUS, vol. 16, no. 9, September 1980, pages 76-80, Newton, US; S.MARGALIT et al.: "Integrated optoelectronics"**
**JAPANESE JOURNAL OF APPLIED PHYSICS, vol. 19, no. 11, November 1980, pages 2191-2196, Tokyo, JP; K.MORIKI et al.: "Single transverse mode operation of terraced substrate GaInAsP/InP lasers at 1.3mum wavelength"**

Courier Press, Leamington Spa, England.

(56) References cited:
**ELECTRONICS INTERNATIONAL, vol. 55, no. 6, March 1982, pages 40-41, New York, US; R.BERESFORD: "Fabrication process points to optical ICs"**

## Description

The present invention is directed to an electro-optic element and to the method of fabrication of the element. The invention is particulary applicable to high speed low cost fiber optic communication systems requiring a monolithic electro-optic transmitter-receiver.

In the prior art there has been described the growth of N type AlGaAs, GaAs, and AlGaAs layers successively on a semi-insulating GaAs substrate for a semiconductor laser device such as shown in US Patents 4,105,955, 4,166, 278 and 4,138,038.

According to the invention, there is provided a solid state electro-optic element comprising a semi-insulating substrate having a substantially planar surface; a depression formed in a portion of said planar surface in order to contain an optoelectronic component, said depression being filled by an epitaxially grown semi conductor layer means of a first conductivity type so that the exposed surface of the layer means is essentially coplanar with said planar surface portion; and a region of said epitaxial layer means having a conductivity type opposcte that of the layer means to form an active part of the optoelectronic component.

According to the invention, there is also provided a method of fabricating a solid state electro-optic element, comprising the steps of preparing a semi-insulating substrate having a substantially planar surface; etching a depression in the planar surface of the substrate to prepare a site for an optoelectronic component; epitaxially growing over said depression a thin semiconductor deposition of a first conductivity type to fill said depression so that the surface of said epitaxially grown deposition is substantially coplanar with said planar surface; and, forming in said epitaxially grown deposition, a region of conductivity type opposite that of the deposition to provide an active portion of the optoelectronic component.

An embodiment of the invention will now be described by way of example, with reference to the accompanying drawings, in which:-

Figure 1 describes a series of steps in the fabrication of a planar GaAs electro-optic transmitter according to the present invention.

Figure 2 is a cross-section of a portion of the transmitter structure derived from the steps of Figure 1,

Figure 3 is a graphical presentation of the relative emission intensity of the diode versus wavelength (nm), and

Figures 4 and 5 are photmicrograph presentations of the cross-section of the transmitter structure.

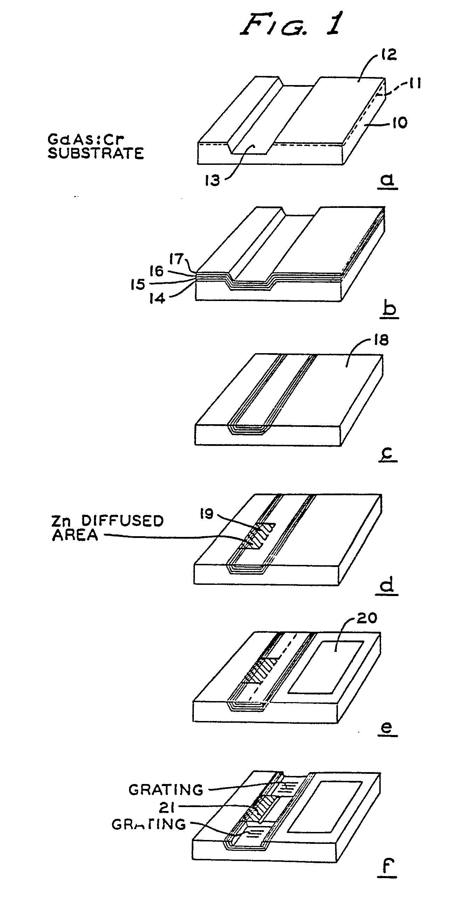

Referring to Figure 1 there is shown a progression of processing steps involved in the fabrication of the planar-structure GaAs electro-optic transmitter. Figure 1a discloses a substrate 10 of semi-insulating GaAs, with an optional GaAs:Cr doped buffer 11, and having a planar surface 12. Etched into the planar surface of the substrate is a "wide-well" or channel (13 for example 100-500 μm wide) to prepare a site for the laser structure. By way of example, the depth of the channel may be on the order of about 2—20 μm. Then by employing VPE (vapor phase epitaxy) or LPE (liquid phase epitaxy) growth the desired *n*-doped AlGaAs-GaAs-AlGaAs-GaAs epitaxial layers 14, 15, 16 and 17 are grown, as shown in Figure 1b, over the planar surface 12 and the well 13. The thickness of the epitaxial layers 14 to 17 are adjusted such that a subsequent chemical-mechanical polishing step produces a new planar surface 18, shown in Figure 1c, where the GaAs:Cr substrate is exposed and the layers 14, 15, 16 and 17 are preserved and remain only in the channel 13. These epitaxial layers grown in the wide well will provide the laser structure. The mechanical polishing exposes the GaAs:Cr substrate over the remainder of the planar surface 18. A mask of Si₃N₄ over the planar surface 18 with a window over a portion of the well area provides for a selective diffusion 19 of Zn into the well structure, as shown in Figure 1d, in order to make the requred p+, p and n regions needed for a transverse junction stripe (TJS) laser structure in the well. In one preferred embodiment the $Al_xGa_{1-x}As$ layers are x=0.35 and the GaAs layer 15 was Te-doped to a carrier concentration of approximately $2 \times 10^{18} cm^{-3}$ on a substrate of GaAs oriented (100). The Zn diffusion extends down through the epitaxial layers 17, 16, 15 and 14 to provide a *p-n* junction in the active GaAs layer 15.

Prior to MESFET fabrication by direct ion implantation the Si₃N₄ is removed and the surface is etched to remove surface damage. When the multiplexer and driver 20 are completed, Figure 1e, the final processing steps are carried out to complete the laser. For illustrative purposes a TJS DBR (distributed Bragg reflector) laser 21 is shown in Figure 1f. In the process steps outlined above, all contact lithograhphic processes are performed on planar surfaces to eliminate the problems encountered in processing non-planar surfaces such as non-uniform photoresist spin-on and mask alignment. Further, the temperature cycling, chemical etches and mechanical stress involved in the fabrication of the MESFETs and the lasers are compatible. Still further, since all the active components are at the surface, the electronic and the optical components can be developed independently during initial stages. The planar structure provides direct access to all the active components and facilities testing and heat sinking.

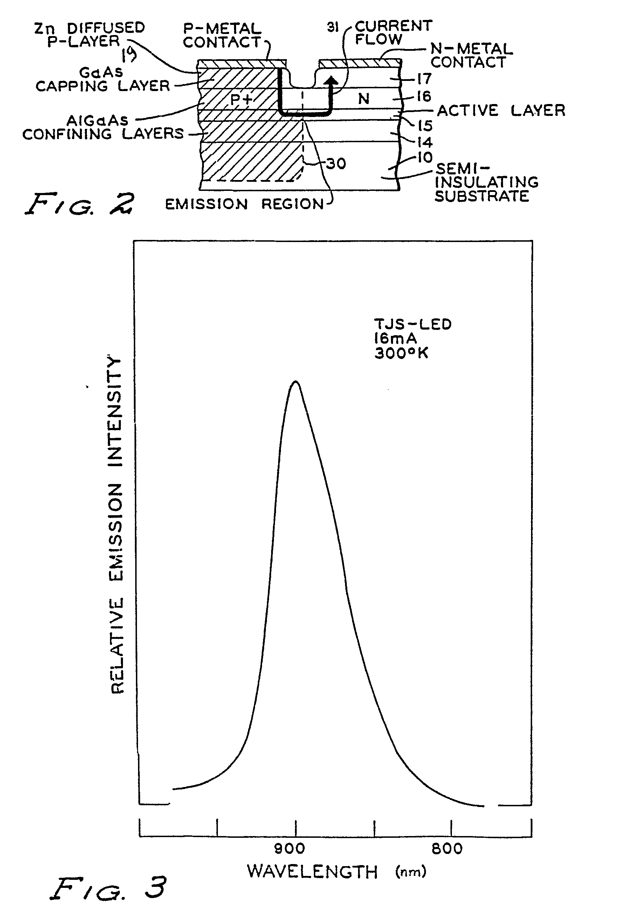

Figure 2 shows the details of a GaAs *p-n* homojunction emitter in the form of a Transverse junction stripe light emitting diode or laser diode fabricated in the well. The layer 10 shows the semi-insulating substrate, then the epitaxial layers includiing the AlGaAs confining layer 14, the GaAs active layer 15, the AlGaAs confining layer 16 and the GaAs cap layer 17. The layers 14 to 17 as deposited are *n*-layers. The cross-hatched portion of Figure 2 represents the Zn diffused area, which is *p* doped, with the junction area being indicated by the dashed line 30. The heavy line 31 is indicative of the predominant current flow path through the diode. The junction can also be formed by the ion implantation of Be in place of the diffusion of Zn.

Figure 3 is a graphical presentation of spectral characteristics and plots the relative emission intensity of the diode on the ordinate axis versus wavelength (nm). It can be seen that in this AlGaAs-GaAs device the emission curve peaks at about 900nm (9000A°).

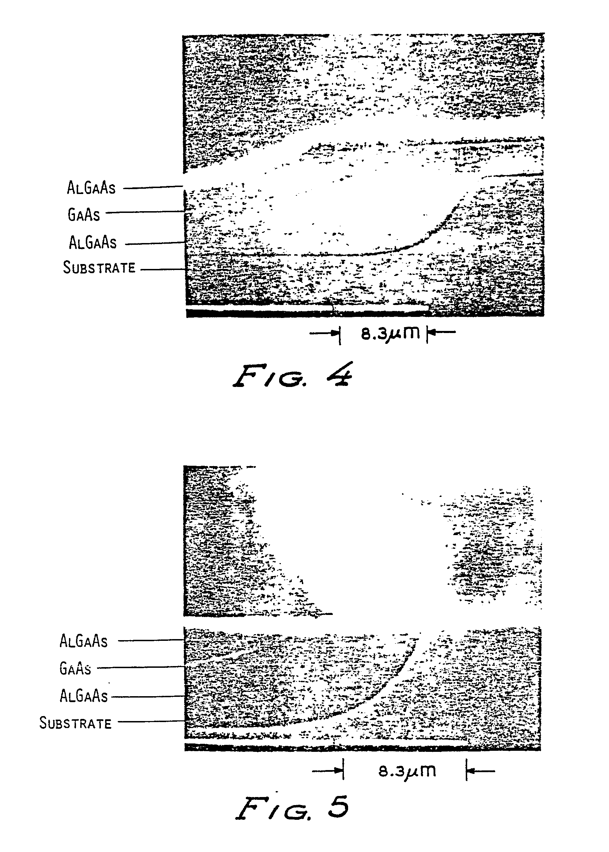

Figures 4 and 5 are photomicrographics of a cross-section of a transverse junction structure grown in an etched wide well. Figure 4 shows the "as grown" AlGaAs, GaAs structure on the substrate. Prior to the heteroepitaxial growth, wide-wells of 450 μm×10 μm were formed by chemical etching in an (100) oriented substrate structure. Subsequently a three layer TJS structure ($Al_xGa_{1-x}As=0.35$; GaAs active layer; $Al_xGa_{1-x}As=0.35$) was grown by liquid phase epitaxy on the entire surface as shown in Figure 4. While the active layer is shown as GaAs throughout the description, it may also be $Al_{x'}Ga_{1-x'}As$ where the x' is not equal to zero. The planar surface was then restored, as shown in Figure 5, by chemical-mechanical polish in which the substrate is again exposed except in the well where the layered structure remains. The Zn diffusion described above can be performed either before or after restoration of the planar surface; however, it is preferable perform the Zn diffusion with the epitaxial layers on the wafer to help protect the GaAs:Cr substrate.

Although the planar structure solid state electrooptic element has been described as fabricated in a GaAs system it may also be fabricated in the same way in a InP (indium phosphide) system. In this case the substrate is InP and the epitaxial layers may be the quaternary semiconductor InGaAsP of the general composition $In_{1-x}Ga_xP_{1-z}As_z$ and in which the respective values of x and z may differ from one layer to another and where $0≤x≤1$ and where $0≤z≤1$.

## Claims

1. Solid state electro-optic element comprising a semi-insulating substrate having a substantially planar surface; a depression formed in a portion of said planar surface in order to contain an optoelectronic component, said depression being filled by an epitaxially grown semiconductor layer means of a first conductivity type so that the exposed surface of the layer means is essentially coplanar with said planar surface portion; and a region of said epitaxial layer means having a conductivity type opposite that of the layer means to form an active part of the optoelectronic component.

2. The element according to Claim 1, wherein the epitaxial semiconductor layer means comprises layers of AlGaAs and GaAs, and wherein the substrate is gallium arsenide.

3. The element according to Claim 1, wherein the semiconductor layers means comprises layers of $Al_xGa_{1-x}As$, and $Al_{x'}Ga_{1-x'}As$ where x' is not equal to zero.

4. The element according to Claim 1, wherein the substrate is InP, and wherein the epitaxial semiconductor layer means includes at least one layer comprised of the general composition $In_{1-x}Ga_xP_{1-z}As_z$.

5. The element according to any one of the preceding claims, wherein said region of opposite conductivity type is diffused down through a section of said semiconductor layer means which comprises first, second and third layers, said first and opposite conductivity type regions forming a *p-n* junction in said layers, said first and third layers acting as confining layers and said second layer being an active layer of a transverse junction stripe optoelectronic component.

6. A method of fabricating a solid state electro-optic element, comprising the steps of preparing a semi-insulating substrate having a substantially planar surface; etching a depression in the planar surface of the substrate to prepare a site for an optoelectronic component; epitaxially growing over said depression a thin semi-conductor deposition of a first conductivity type to fill said depression so that the surface of said epitaxially grown deposition is substantially coplanar with said planar surface; and, forming in said epitaxially grown deposition, a region of conductivity type opposite that of the deposition to provide an active portion of the optoelectronic component.

7. The method according to Claim 6 and further comprising the stop of fabricating MESFETs on a different portion of said planar surface by direct ion implantation.

8. The method of Claim 6 or 7, wherein the deposition comprises first, second and third layers, and including the steps of chemical-mechanical polishing said epitaxially covered planar surface to re-expose said substrate and establishing a new substantially planar surface with planar surface effectively includes the epitaxially grown layers in said depression; and, diffusing zinc down into a portion of said epitaxially grown layers and thereby forming a *p-n* junction, whereby the first and third layers are confining layers and the second layer is the active layer of a transverse junction stripe optoelectronic component.

9. The method of Claim 6 or 7, wherein said depression is filled with thin layers of $Al_xGa_{1-x}As$ or $Al_xGa_{1-x}As$ and $Al_{x'}Ga_{1-x'}As$ (where x' is not equal to zero).

10. The method of Claim 6, 7, 8 or 9, wherein the depression is between 2 and 20 μm deep.

## Patentansprüche

1. Elektrooptisches Festkörperelement aufweisend ein halbisolierendes Substrat mit einer im wesentlichen planaren Oberfläche; eine Vertiefung geformt in einem Teil der planaren Oberfläche, die mit einer Halbleiterschichteinrichtung gefüllt ist, so daß die freie Oberfläche der Schichteinrichtung im wesentlichen koplanar zu dem Teil der planaren Oberfläche ist; und eine Region der Epitaxie-Schichteinrichtung mit einem Leitungstyp entgegengesetzt zum dem der Schichteinrichtung, um den aktiven Teil der elektrooptischen Komponente zu bilden.

2. Element nach Anspruch 1, worin die Epitaxie-Halbleiterschichteinrichtung Schichten aus AlGaAs und GaAs aufweist und worin das Substrat Gallium-Arsenid ist.

3. Element nach Anspruch 1, worin die Halbleiterschichteinrichtung Schichten aus $Al_xGa_{1-x}As$ und $Al_x'Ga_{1-x}'As$ aufweist, wobei x' nicht gleich Null ist.

4. Element nach Anspruch 1, worin das Substrat InP ist, und worin die Epitaxie-Halbleiterschichteinrichtung mindestens eine Schicht enthält, die aus der allgemeinen Zusammensetzung $In_{1-x}Ga_xP_{1-z}As_z$ besteht.

5. Element nach einem der vorhergehenden Ansprüche, worin diese Region des entgegengesetzten Leitungstyps durch einen Abschnitt der Halbleiterschichteinrichtung diffundiert wird, die erste, zweite und dritte Schichten aufweist, wobei diese erste Region un die Region entgegengesetzten Leitungstyps einen pn-Übergang in diesen Schichten bildet, und wobei erste und dritte Schichten als Begrenzungsschichten wirken und die zweite Schicht eine aktive Schicht einer Transversal-Übergangsstreifen-Optoelektronischen Komponente ist.

6. Verfahren zur Herstellung eines elektrooptischen Festkörperelements, das umfaßt die Schritte zum Erzeugen eines halbisolierenden Substrats mit einer im wesentlichen planaren Oberfläche; zum Ätzen einer Vertiefung in die planare optoelektronische Komponente, um einen Platz für eine optoelektronische Komponente zu schaffen; zum epitaxialen Aufwachsen auf der Vertiefung einer dünnen Halbleiterablagerung, um im wesentlichen die Vertiefung zu füllen; und zum Ausbilden in der epitaxial gewachsenen Ablagerung ein Material mit einem entgegengesetzten Leitungstyp zu dem der Ablagerung, um einen aktiven Teil der optoelektronischen Komponente zu erzeugen.

7. Verfahren nach Anspruch 6, weiterhin aufweisend den Schritt zum Herstellen von MESFETs auf einem anderen Teil der planaren Oberfläche durch direkte Ionenimplantation.

8. Verfahren nach Anspruch 6 oder 7 worin die Ablagerung aus vielen Schichten besteht und aufweisend die Schritte des chemisch-mechanischen Polierens der epitaxial abgedeckten planaren Oberfläche, um das Substrat wieder zu befreien, und zum Einrichten einer neuen im wesentlichen planaren Oberfläche, die effektiverweise die epitaxial gewaschsenen Schichten in der Vertiefung enthält; und zum Diffundieren von Zink in einem Teil der epitaxial gewachsenen Schichten, wodurch ein pn-Übergang erzeugt wird, wobei die ersten und dritten Schichten Begrenzungsschichten sind und die zweite Schicht die aktive Schicht einer Transversalen-Übergangsstreifen-Optoelektronischen-Komponente ist.

9. Verfahren nach Anspruch 6 oder 7, wobei die Vertiefung mit dünnen Schichten aus $Al_xGa_{1-x}As$ oder $Al_xGa_{1-x}As$ und $Al_x'Ga_{1-x}'As$ (wobei x' nicht gleich Null ist) gefüllt ist, so daß die Oberfläche der Epitaxieschichten in der Vertiefung im wesentlichen koplanar mit der planaren Oberfläche ist; und wobei eine Diodenregion in den epitaxial dünnen Filmschichten erzeugt wird, wobei die Diodenregion eine aktive Region der optoelektronischen Struktur ist.

10. Verfahren nach Anspruch 6, 7, 8 oder 9, wobei die Vertiefung zwischen 2 und 20 μm tief ist.

**Revendications**

1. Elément électro-optique à l'état solide comprenant un substrat semi-isolant doté d'une surface sensiblement plane, une dépression ménagée dans une partie de ladite surface plane et remplie d'un système à couches semi-conductrices, de manière que la surface exposée du système à couches soit essentiellement coplanaire avec ladite partie de surface plane, et une région dudit système à couches épitaxiales possédant un type de conductivité opposé à celui du système à couches pour former la partie active du composant électro-optique.

2. Elément selon la revendication 1, dans lequel le système à couches semi-conductrices épitaxiales comprend des couches d'AlGaAs et de GaAs et dans lequel le substrat est l'arséniure de gallium.

3. Elément selon la revendication 1, dans lequel le système à couches semi-conductrices comprend des couches d'$Al_xGa_{1-x}As$ et d'$Al_x'Ga_{1-x}'As$ où x' n'est pas égal à zéro.

4. Elément selon la revendication 1, dans lequel le substrat est InP et le système à couches semi-conductrices épitaxiales comprend au moins une couche de composition générale $In_{1-x}Ga_xP_{1-z}As_z$.

5. Elément selon l'une quelconque des revendications précédentes, dans lequel la région de type de conductivité opposé est soumise à une diffusion vers le bas à travers une section dudit système à couces semi-conductrices constitué par les première, deuxième et troisième couches, ladite première région et celle du type de conductivité opposé formant une jonction p-n dans lesdites couches, les première et troisième couches jouant le rôle de couches de confinement et la deuxième couche étant la couche active d'un composant optoélectronique à bande de jonction transversale.

6. Procédé de fabrication d'un élément électrooptique à l'état solide comprenant les étapes de préparation d'un substrat semi-isolant doté d'une surface sensiblement plane; de gravure d'une dépression dans la surface plane du substrat en vue de la préparation d'un site pour un composant opto-électronique; de croissance épitaxiale par dessus ladite dépression d'un mince dépôt semi-conducteur pour remplir pratiquement la dépression; et de formation, dans ledit dépôt épitaxial, d'un matériau d'un type de conductivité opposé à celui du dépôt en vue de réaliser la partie active du composant optoélectronique.

7. Procédé selon la revendication 6 et comprenant en outre l'étape de fabrication de transistors à effet de champ métalliques semi-conducteurs (MESFET) sur une partie différente de ladite surface plan par implantation ionique directe.

8. Procédé selon la revendication 6 ou 7, dans lequel le dépôt est multicouche et comprend les étapes de polissage chimico-mécanique de ladite surface plane recouverte par épitaxie en vue de la réexposition dudit substrat et de la réalisation d'une nouvelle surface sensiblement plane, ladite surface plane abritant effectivement les couches épitaxiales dans ladite dépression, et de diffusion de Zn vers le bas dans une partie des couches épitaxiales avec formation d'une jonction *p-n*, moyennant quoi les première et troisième couche est la couches de confinement et la deuxième couche est la couche active d'un élément optoélectronique à bande de jonction transversale.

9. Procédé selon la revendication 6 ou 7, dans lequel ladite dépression est remplie de minces couches d'$Al_xGa_{1-x}As$ ou d'$Al_xGa_{1-x}As$ et d'$Al_x'Ga_{1-x}'As$ (où x' n'est pas égal à zéro) de manière que le surface desdites couches épitaxiales dans la dépression soit pratiquement coplanaire avec ladite surface plane et dans lequel il se forme une région de diode dans les minces couches épitaxiales, la région de diode étant une région active de la structure optoélectronique.

10. Procédé selon la revendication 6, 7, 8 ou 9, dans lequel la dépression a une profondeur de 2 à 20 μm.

## FIG. 1

GaAs:Cr
SUBSTRATE

12
11
10

13

a

17
16
15
14

b

18

c

Zn DIFFUSED
AREA

19

d

20

e

GRATING
21
GRATING

f

Zn DIFFUSED
P-LAYER          P-METAL                31   CURRENT
    19           CONTACT                      FLOW          N-METAL
                                                            CONTACT
GaAs
CAPPING LAYER ─────────                                    ──── 17

                         P+                    N          ──── 16
AlGaAs                                                         ──── ACTIVE LAYER
CONFINING LAYERS ──────                                    ──── 15
                                                          ──── 14
                                                          ──── 10
                                    ──30                       SEMI-
                                                              INSULATING
   *FIG. 2*         EMISSION REGION                          SUBSTRATE

TJS-LED
16mA
300°K

RELATIVE EMISSION INTENSITY

900                    800
WAVELENGTH  (nm)

*FIG. 3*

2

ALGaAs ——
GaAs ——
ALGaAs ——
SUBSTRATE ——

→| 8.3μm |←

*FIG. 4*

ALGaAs ——
GaAs ——
ALGaAs ——
SUBSTRATE ——

→| 8.3μm |←

*FIG. 5*